# EUROPEAN PATENT SPECIFICATION

(11) **EP 0 379 173 B1**
(45) Date of publication and mention of the grant of the patent: **08.06.1994**
(21) Application number: 90100922.5
(22) Date of filing: 17.01.1990
(51) Int. Cl.: G03F 7/075

(54) **Energy beam lithography resist materials**
Resist-Materialien für Lithographie mittels eines Elektronen- oder Röntgenstrahls
Matériaux de réserve pour lithographie avec faisceau électronique ou rayons X

(30) Priority: 20.01.1989 JP 12447/89
(43) Date of publication of application: 25.07.1990
(73) Proprietor: FUJITSU LIMITED, Kawasaki-shi, Kanagawa 211 (JP)
(72) Inventor: Kotachi, Akiko, c/o Fujitsu Limited, Kawasaki-shi, Kanagawa 211 (JP); Takechi, Satoshi, c/o Fujitsu Limited, Kawasaki-shi, Kanagawa 211 (JP); Nakamura, Yuko, c/o Fujitsu Limited, Kawasaki-shi, Kanagawa 211 (JP)
(74) Representative: Greenstreet, Cyril Henry

(56) References cited:
- EP-A- 0 271 708
- PATENT ABSTRACTS OF JAPAN vol. 9, no. 62 (P-342)(1785) 19 March 1985, & JP-A-59 197036
- PATENT ABSTRACTS OF JAPAN vol. 12, no. 95 (P-681)(2942) 29 March 1988, & JP-A-62 229141

## Description

This invention relates to resist materials having high resistance to etching by oxygen-containing plasma and a high sensitivity to exposure to an energy beam such as an electron beam or an X-ray beam, and more particularly concerns resist materials useable in electron-beam or X-ray lithography for forming patterns of submicron dimensions. The invention also relates to methods of using such resist materials.

In fabricating semiconductor integrated circuits, thin film technology and photolithography technology are widely used. With the trend towards higher degrees of integration of integrated circuits, electron beam and X-ray lithography (hereinafter, energy beam lithography, such as electron beam and X-ray lithography, will be referred to as e-beam/X-ray lithography, for brevity) are gradually finding practical application in the fabrication of LSIs and VLSIs.

In photolithography technology, for example, for forming an aluminium wiring pattern on a semiconductor substrate, a resist layer is coated on a thin aluminium layer. The resist layer is selectively exposed to ultraviolet rays using a mask and then developed, resulting in the formation of a resist pattern in which the aluminium layer is selectively exposed (revealed). Thereafter, the substrate is subjected to either a wet or dry etching process for removing the exposed (revealed) portions of the aluminium layer. After the remaining resist layer has been removed by an ashing process, the aluminium pattern is provided on the substrate.

The above photolithography technology has a resolution limitation of around 1 micron and, therefore, is not suitable for forming a resist pattern having dimensions less than 1 micron.

On the other hand, e-beam/X-ray lithography utilises radiation of much shorter wavelength than the light wavelengths used in photolithography. In e-beam lithography, an electron beam having an energy level of about 20 to 30 KeV (kilo-electron-volts), corresponding to a wavelength of about 0.1 Angstrom is irradiated on to and swept over a resist layer. In X-ray lithography, an X-ray source capable of radiating X-rays of a wavelength of several Angstroms is utilised. Therefore, e-beam/X-ray lithography is suitable for forming resist patterns having dimensions less than 1 micron; in other words, for forming fine patterns of submicron dimensions or geometries.

There is another factor which can result in deterioration of the quality of formed resist patterns.

In some cases, a specific layer to be patterned by an e-beam/X-ray lithography process has a step structure on a substrate, the step being formed by an underlying structure previously formed. The step sometimes has a height of 1 to 2 microns. When a single resist layer is used in lithography, fine resist patterns cannot be expected in such cases.

In order to deal with the above step problem, a multilayer resist method has been developed and applied. In a simple case, a double-layer resist method is used. A first (lower) resist layer serves to provide a planar substrate surface and has a comparatively large thickness. Phenolnovolak resin or cresolnovolak resin, for example, can be used as a material for the first resist layer. The material of the first resist layer is selected from those materials which are easily removed by a dry etching process comprising oxygen plasma. The first resist layer is coated on the substrate by a spin-coating method and has a thickness of, for example, about 2 microns, and has a flat surface. A second (upper) resist layer is coated on the first resist layer and has a thickness of about 0.2 to 0.3 microns. The material of the second resist layer is required to have a high resistance to etching by oxygen-containing plasma.

When the second resist layer has been exposed selectively to an e-beam and developed, the remaining second resist layer pattern exhibits a high resistance to etching during a subsequent dry etching process using oxygen-containing plasma. Therefore, the second resist layer pattern is transferred to the underlying first resist layer, resulting in the formation of a first resist layer pattern similar to the second resist layer pattern.

A homopolymer of trimethylsilylmethyl methacrylate, shown in the following structural formula (1), is a known positive-type resist material which has a high resistance to reactive ion etching (abbreviated as RIE) using an oxygen-comprising gas.

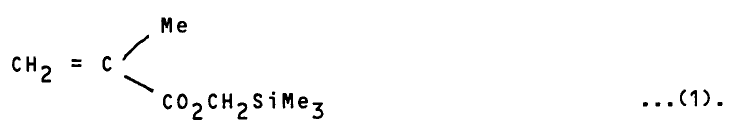

Though the above polymer exhibits a high resistance to oxygen plasma during dry etching, sensitivity to e-beam exposure is not good.

For increased sensitivity, Japanese Unexamined Patent Publication SHO-62-229141, issued on 7th October 1987, by Watanabe et al., discloses a polymer having a high sensitivity to e-beam exposure. A monomer disclosed in this reference, for example, has the following structural formula, wherein the alpha-methyl group of the trimethylsilylmethyl methacrylate shown by formula (1) is replaced by a chlorine atom (Cl).

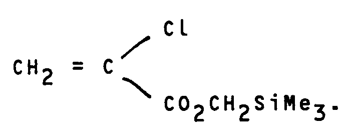

The above-improved positive-type resist material is most suitable when subjected to e-beam irradiation of a quantity in a range less than a specified value. When a resist layer of this material is subjected to e-beam irradiation exceeding this range, the resist sometimes exhibits a negative-type characteristic.

An embodiment of the present invention can provide a positive-type resist material which has a high resistance to oxygen plasma during dry etching and a high sensitivity to a wide range of e-beam/X-ray irradiation and further can accommodate a wide range of qualities of irradiation.

An embodiment of the present invention can provide a positive-type resist material having a high sensitivity to e-beam/X-ray irradiation and which can be utilised for an outermost resist layer in a multi-layer resist method.

An embodiment of the present invention can provide a positive-type resist material having a high resistance to oxygen plasma in a dry etching process, when the resist material has not been exposed to e-beam/X-ray irradiation and remains after development of the resist layer.

An embodiment of the present invention can provide a positive-type resist material having characteristics of both high sensitivity to e-beam/X-ray irradiation and a high resistance to oxygen plasma in a subsequent dry etching process when not exposed to e-beam/X-ray irradiation.

An embodiment of the present invention provides a positive-type resist material comprising a copolymer of a first monomer of a silicon-containing methacrylic ester and a second monomer of either an acrylic ester or acrylonitrile, the alpha-position of the second monomer being substituted by an electron-attracting group. The first monomer has a high resistance to oxygen plasma in a dry etching process and the second monomer has a high sensitivity to e-beam/X-ray irradiation.

Reference is made, by way of example, to the accompanying drawings, in which:
Figs. 1 to 3 are schematic cross-sectional views of a semiconductor integrated circuit at different sequential stages, a resist material embodying the present invention being used for a double-layer resist method in lithography processes involved, and
Fig. 4 is a graph illustrating sensitivity curves of typical resist materials (curves A and B) embodying the present invention and a known resist material (curve C) for comparison, and curve D illustrates that a typical known positive-type resist material has a negative-type characteristic when overexposed to e-beam irradiation.

First, a method of forming fine resist layer patterns in a lithography process will be explained for a case in which a multi-layer resist method is used.

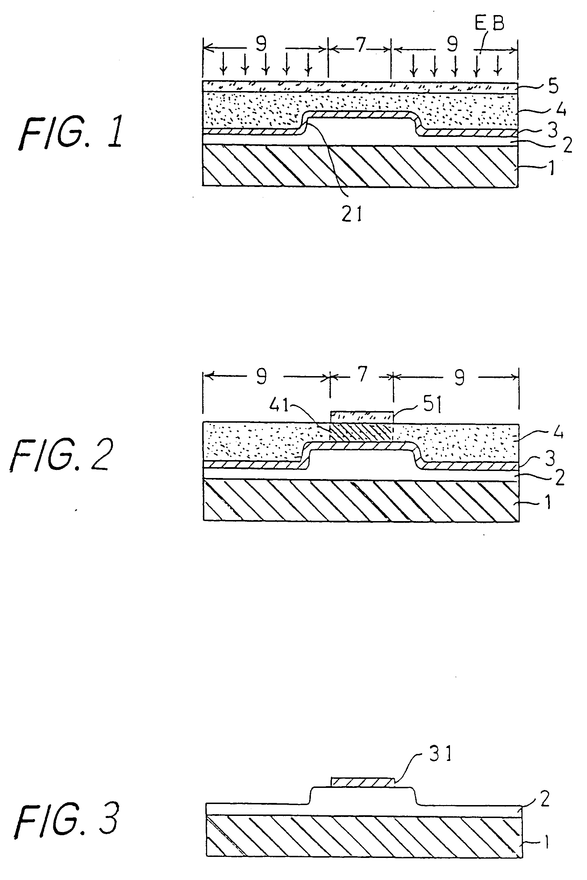

Fig. 1 shows schematically a partial cross-section of a semiconductor structure when two resist layers are formed thereon. For clarity, a semiconductor substrate 1 is assumed to have a layer structure 2, which has been formed in previous fabrication processes and has a stepped portion 21. In order to form wiring patterns of an aluminium layer, an aluminium layer 3 is first deposited on an entire surface of the layer structure 2. A first resist layer 4 of a thickness of about 2 microns is spin-coated on the aluminium layer 3. Phenolnovolak resin, for example, is used as the material of the first resist layer 4. Because the first resist layer has sufficient thickness to embed the stepped portion 21, the surface thereof is level. Thereafter, a second resist layer 5, which is prepared in accordance with an embodiment of the present invention, is coated on the first resist layer 4 to a thickness of about 3000 Angstroms.

Surface regions 9 of the second resist layer 5 are selectively subjected to e-beam exposure. Thereafter, the second resist layer 5 is subjected to a development process. The resist layer 5 in the exposed regions 9 is removed whilst the layer 51 in a non-exposed region 7 remains as shown in Fig. 2.

Next, the entire surface is subjected to a reactive ion etching (RIE) process using oxygen-including gas, which has an anisotropic characteristic. The first resist layer 4 in the exposed regions 9 is removed and the aluminium layer 3 in these regions 9 is exposed (revealed) in this process. However, because the second resist layer 51 has a high resistance to the oxygen plasma, the resist layer 51 remains with the first resist layer 41 thereunder during this etching process.

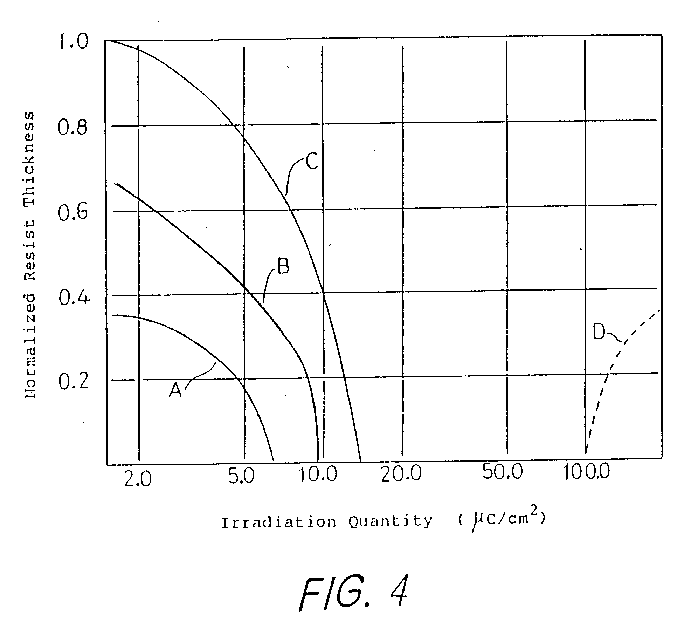

Next, the exposed (revealed) aluminium layer 3 and the remaining second resist layer 51 are subjected to another dry etching process using a halide, for example, chloride-compound-comprising gas, and both layers are removed. Finally, the remaining first resist layer 41 is removed by an ashing process, leaving a fine aluminium layer pattern 31 as shown in Fig. 3.

A resist material embodying the present invention comprises a copolymer of a first monomer of a silicon-containing methacrylic ester and a second monomer of either an acrylic ester or acrylonitrile, the alpha-position of the second monomer being substituted by an electron-attracting group.

The first monomer of silicon-containing methacrylic ester is shown in the following general structural formula (2). 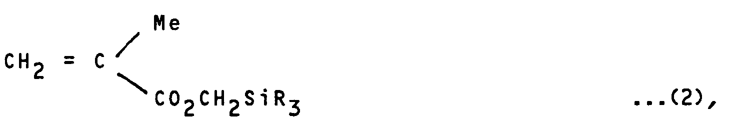
where R denotes an alkyl group or a phenyl group.

A homopolymer of the above silicon-containing methacrylic ester exhibits a high resistance to oxygen plasma, but has a poor sensitivity to e-beam/X-ray irradiation.

In order to improve sensitivity to e-beam/X-ray irradiation, a resist material embodying the present invention comprises a copolymer which is provided by copolymerisation of above first monomer shown by formula (2) and a second monomer of either an acrylic ester or acrylonitrile, of which the alpha-position is substituted by an electron-attracting group.

As an electron-attracting group, any group selecting the following can be used: a halogen group, a cyano group (CN), and a CH₂CO₂R group. When the electron-attracting group is denoted as X, one of the second monomers, an acrylic ester in which the alpha-position is substituted by X, is represented by the following structural formula: 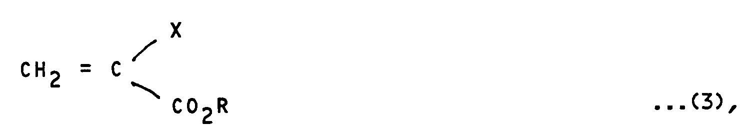
where R denotes an alkyl group or a phenyl group.

The other second monomer, acrylonitrile in which the alpha-position is substituted by X, is represented by the following structural formula:

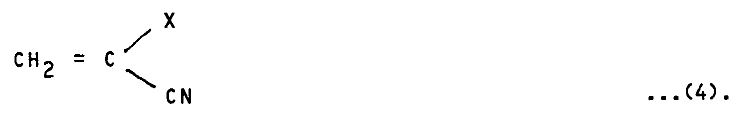

In copolymerising the first and second monomers, a copolymerisation ratio is preferably selected to be in the range from 10:1 to 2:1 and, further, the molecular weight of the copolymer is preferably in the range 500,000 to 3,000,000.

Examples of resist materials in accordance with embodiments of the present invention are described below.
1. First Example
   When a trifluoromethyl group (CF₃) is used for X and a trifluoroethyl group (CH₂CF₃) for R in formula (3), α-trifluoromethyl (2,2,2-trifluoroethyl) acrylate shown by the following formula (5) is utilised as the second monomer. 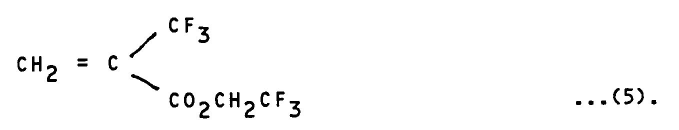
   As the first monomer, trimethylsilylmethyl methacrylate, wherein a methyl group is substituted for alkyl group R in the formula (2), is used in this first example.
   The first and second monomers, trimethylsilylmethyl methacrylate and α-trifluoromethyl (2,2,2-trifluoroethyl) acrylate, are copolymerised, and the copolymer has a copolymerisation ratio of 7:3 and a molecular weight of about 800,000. The copolymer is dissolved in toluene, and a copolymer solution of 30 g/l is used as a positive-type resist material in accordance with the first example.
   The resist material of the first example was coated on a silicon wafer to a thickness of about 3000 Angstroms. After a baking process, the resist layer was subjected to e-beam exposure using an acceleration voltage of 20 KeV. After exposure, the resist layer was developed in n-hexane for two minutes. In Fig. 4, the sensitivity of the resist material of the first example is illustrated by curve A, in which sensitivity is indicated by curves representing normalised remaining resist thickness corresponding to respective irradiation quantities. It is found that this resist material has a sensitivity of about 6.4 »C/cm².
   As a test for obtaining data relevant to its resistance to oxygen plasma, the resist material of the first example was subjected to RIE for 20 minutes under conditions of oxygen gas flow of 50 sccm, a degree of vacuum of 0.15 Torr and input RF (radio frequency) power of 300 watts. The test result indicated that the thickness consumption of the resist layer was about 1000 Angstroms.
2. Second Example
   In the second example, α-trifluoromethyl (2,2,2-trifluoroethyl) acrylate illustrated by formula (5) is used as the second monomer.
   (Diphenylmethylsilyl)methyl methacrylate illustrated by the following formula (6) wherein groups R in the formula (2) are replaced by two phenyl groups and one methyl group, is used as a first monomer: 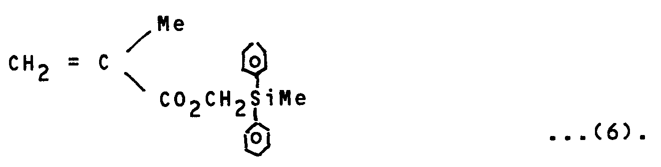
   A copolymer of the first and second monomers having a copolymerisation ratio of 8:1 and a molecular weight of about 800,000 is dissolved in cyclohexane, and the copolymer solution of 30 g/l is used as a positive-type resist material of the second example.
   The resist material of the second example was coated on a silicon wafer to a thickness of about 3000 Angstroms. After a baking process, the resist layer was subjected to an e-beam exposure having an acceleration voltage of 20 KeV. After the exposure, the resist layer was developed in a 3:2 mixed solution of n-octyl alcohol and methyl alcohol for 5 minutes. It was found that the resist material has a sensitivity of about 8.0 »C/cm².
   As a test for obtaining data relevant to its resistance to oxygen plasma, the resist material of the second example was subjected to RIE for 20 minutes under the conditions of oxygen gas flow of 50 sccm, a degree of vacuum of 0.15 Torr and input RF power of 300 watts. The test result indicates that the thickness consumption of the resist layer was about 2200 Angstroms.
3. Third Example
   In the third example, α-chloroacrylonitrile wherein the alpha-position of acrylonitrile in formula (4) is substituted by chlorine, shown by the formula (6), is used as a second monomer. 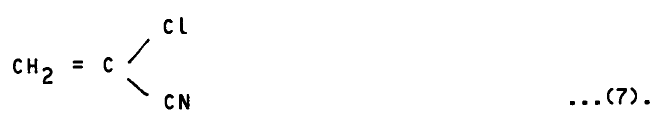
   As a first monomer, trimethylsilylmethyl methacrylate is used, which is the same monomer as used in the first example.
   A copolymer of the first and second monomers having a copolymerisation ratio of 7:2 and a molecular weight of about 800,000 is dissolved in ethylbenzene, and the copolymer solution of 60 g/l used as a positive-type resist material of the third example.
   The resist material of the third example was coated on a silicon wafer to a thickness of about 3000 Angstroms. After a baking process, the resist layer was subjected to an e-beam exposure having an acceleration voltage of 20 KeV. After the exposure, the resist layer was developed in a 5:1 mixed solution of water and ethylalcohol for 10 minutes. The sensitivity curve of this resist material is indicated by curve B of Fig. 4. It was found that the resist material has a sensitivity of about 9.6 »C/cm².
   As a test for obtaining data relevant to resistance to oxygen plasma, the resist material of the third example was subjected to RIE for 20 minutes under the conditions of oxygen gas flow of 50 sccm, a degree of vacuum of 0.15 Torr and an input electrical discharge power of 300 watts. The test result indicated that the thickness consumption of the resist layer was about 3000 Angstroms.
4. Comparison Tests
   (1) Comparison Data 1
      A toluene solution of a homopolymer of trimethylsilylmethyl methacrylate was used as a resist material for comparison tests. Test pieces were formed and thereafter exposed in the same way as described in relation to the examples above. The resist layer was developed in a 10:1 mixed solution of 2-propanol and water for 20 minutes. It was found that the resist material had a sensitivity of about 14 »C/cm² and, as data pertaining to resistance to oxygen plasma, thickness consumption data of 1000 Angstroms was obtained under the same test conditions.
      In Fig. 4, sensitivity of the homopolymer of trimethylsilylmethyl methacrylate is indicated by curve C.
   (2) Comparison Data 2
      The resist material of the first lower resist layer 4 in Figs. 1 and 2, which is used for levelling the substrate surface, was subjected to an oxygen plasma test for obtaining a data pertinent to its resistance to oxygen plasma. Test conditions were the same as those applied in the above examples. A resist layer of novolak resin having the trade name OFPR-800, made by Tokyo-Oka-Kogyo, showed a thickness consumption of 12 microns, which is much larger than the thickness obtained in the first to third examples.

The effects achieved by embodiments of the present invention, in accordance with Examples 1 to 3, can be summarised thus.

### (1) Resistance against oxygen plasma

As explained in relation to the first to third examples, thickness consumptions of the resist layers, when subjected to oxygen-containing plasma etching, are 1000, 2200 and 3000 Angstroms respectively. The data show that consumptions are about 1/120, 1/50 and 1/40 respectively of the data obtained for OFPR-800 novolak resin.

Resistance to oxygen plasma is very good for resist materials embodying the present invention. This is due to a silicon atom comprised in a methacrylic acid ester in the copolymer. Therefore, a known homopolymer resist material comprising only a methacrylic acid ester such as trimethylsilylmethyl methacrylate also shows a strong resistance to oxygen plasma as described in comparison data (1).

### (2) Sensitivity to e-beam irradiations

The resist materials of Examples 1 to 3 have e-beam sensitivities of 6.4 »C/cm², 8.0 »C/cm² and 9.6 »C/cm², respectively. The data shows that sensitivity is improved by about 1.5 to 2 times in comparison with the known methacrylic acid ester homopolymer. It seems that resist material embodying the present invention is of a copolymer comprising a second monomer of either an acrylic ester or acrylonitrile, of which the alpha-position is substituted by an electron-attracting group, such as a trifluoromethyl group (CF₃) or a halogen group (Cl), and that this structure causes easy decomposition of the copolymer of e-beam irradiation.

Another feature of the present invention is that the resist material does not show a turnover or reversal of its characteristics when it is overexposed to e-beam/X-ray. The known positive-type resist material exhibits a negative-type characteristic as typically shown by a broken-line curve D of Fig. 4 when it is overexposed to e-beam irradiation of, for example, larger than 100 »C/cm².

In an embodiment of the present invention a positive-type resist material, for forming resist patterns having submicron geometries on a substrate, comprises a copolymer of a first monomer of silicon containing methacrylic ester and a second monomer of either acrylic ester or acrylonitrile, the alpha-position of the second monomer being substituted by an electron-attracting group. The first monomer has a high resistance against oxygen plasma and the second monomer has a high sensitivity for e-beam/X-ray irradiation. As the electron attracting group, a trifluoromethyl group, a halogen group, a cyano group and a CH₂CO₂R group are used. Possible embodied first monomers are, inter alia, trimethylsilylmethyl methacrylate and (diphenylmethylsilyl)methyl methacrylate, and possible second monomers are, inter alia, α-trifluoromethyl (2,2,2-trifluoroethyl) acrylate and α-chloroacrylonitrile.

## Claims

1. A resist material comprising a copolymer of a silicon containing methacrylic ester and of either an acrylic ester or acrylonitrile, the alpha-position of the acrylic ester or acrylonitrile being substituted by an electron-attracting group.

2. A resist material as claimed in claim 1, wherein said electron-attracting group is a trifluoromethyl group (CF₃), a halogen group, a cyano group (CN) or a CH₂CO₂R group.

3. A resist material as claimed in claim 1 or 2, wherein said silicon-containing methacrylic ester is trimethylsilylmethyl methacrylate shown as follows:

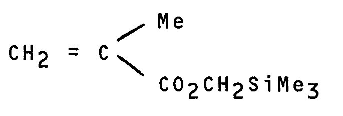

4. A resist material as claimed in claim 1 or 2, wherein said silicon-containing methacrylic ester is (diphenylmethylsilyl)methyl methacrylate shown as follows:

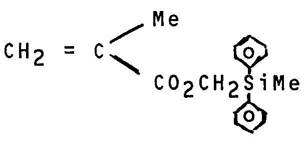

5. A resist material as claimed in claim 1, wherein said acrylic ester of which the alpha-position is substituted by an electron-attracting group is α-trifluoromethyl (2,2,2-trifluoroethyl) acrylate, shown as follows:

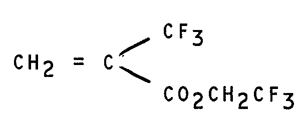

6. A resist material as claimed in claim 1, wherein said acrylonitrile of which the alpha-position is substituted by an electron-attracting group, is α-chloroacrylonitrile, shown as follows:

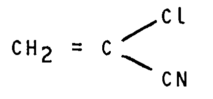

7. A method of forming a resist pattern comprising the steps of:
forming a first resist layer on a substrate or on an underlying structure, and forming a second resist layer thereon,
irradiating said second resist layer selectively with e-beam/X-ray radiation, and removing the second resist layer and exposing (revealing) the first resist layer thereunder in selectively irradiated regions by a developing process, and
subjecting the entire surface of the substrate to a dry etching process using an oxygen-containing gas,
wherein the material of said second resist layer is the resist material of claim 1.

## Patentansprüche

1. Resistmaterial, welches ein Copolyer eines Silizium enthaltenden Methacrylesters und entweder eines Acrylesters oder Acrylonitrils umfaßt, wobei die Alpha-Stellung des Acrylesters oder Acrylonitrils durch eine elektronenanziehende Gruppe substituiert ist.

2. Resistmaterial nach Anspruch 1, worin die genannte elektronenanziehende Gruppe eine Trifluormethyl-Gruppe (CF₃), eine Halogen-Gruppe, eine Cyano-Gruppe (CN) oder eine CH₂CO₂R-Gruppe ist.

3. Resistmaterial nach Anspruch 1 oder 2, worin der genannte Silizium enthaltende Methacrylester Trimethylsilylmethylmethacrylat ist, das wie folgt dargestellt wird:

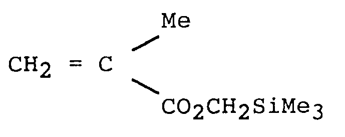

4. Resistmaterial nach Anspruch 1 oder 2, worin der genannte Silizium enthaltende Methacrylester (Diphenylmethylsilyl)-methylmethacrylat ist, das wie folgt dargestellt wird:

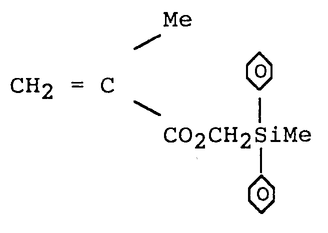

5. Resistmaterial nach Anspruch 1, worin der genannte Acrylester, dessen Alpha-Stellung durch eine elektronenanziehende Gruppe substituiert ist, α-Trifluormethyl-(2,2,2-trifluorethyl)-acrylat ist, das wie folgt dargestellt wird:

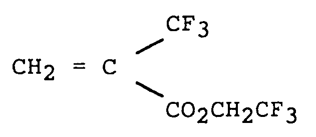

6. Resistmaterial nach Anspruch 1, worin das genannte Acrylonitril, dessen Alpha-Stellung durch eine elektronenanziehende Gruppe substituiert ist, α-Chloracrylonitril ist, das wie folgt dargestellt wird:

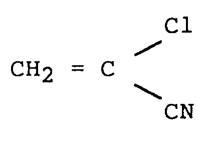

7. Verfahren zur Bildung eines Resistmusters, welches die Schritte umfaßt:
Bilden einer ersten Resistschicht auf einem Substrat oder einer darunterliegenden Struktur, und Bilden einer zweiten Resistschicht darauf,
selektives Einstrahlen von e-Strahlung/Röntgenstrahlung auf die genannte zweite Resistschicht, und Entfernen der zweiten Resistschicht und Exponieren (Freilegen) der ersten Resistschicht darunter in selektiven Einstrahlungszonen durch ein Entwicklungsverfahren, und
Unterwerfen der gesamten Oberfläche des Substrats einem Trockenätzverfahren unter Verwendung eines sauerstoffhaltigen Gases,
bei welchem das Material der genannten zweiten Resistschicht das Resistmaterial nach Anspruch 1 ist.

## Revendications

1. Matière de résist comprenant un copolymère d'un ester méthacrylique contenant du silicium et d'un ester acrylique ou d'acrylonitrile, l'ester acrylique ou l'acrylonitrile étant substitués en position α par un groupe attracteur d'électrons.

2. Matière de résist selon la revendication 1, dans laquelle ledit groupe attracteur d'électrons est un groupe trifluorométhyle (CF₃), un groupe halogène, un groupe cyano (CN) ou un groupe CH₂CO₂R.

3. Matière de résist selon la revendication 1 ou 2, dans laquelle ledit ester méthacrylique contenant du silicium est le méthacrylate de triméthylsilylméthyle représenté de la façon suivante:

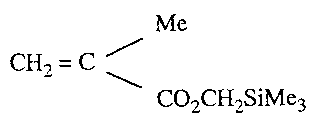

4. Matière de résist selon la revendication 1 ou 2, dans laquelle l'ester méthacrylique contenant du silicium est le méthacrylate de (diphénylméthylsilyl)méthyle représenté de la façon suivante:

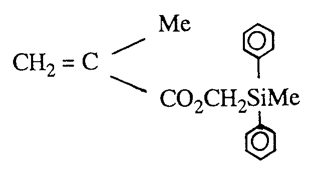

5. Matière de résist selon la revendication 1, dans laquelle ledit ester acrylique substitué en position α par un groupe attracteur d'électrons est l'α-trifluorométhylacrylate de 2,2,2-trifluoréthyle représenté de la façon suivante:

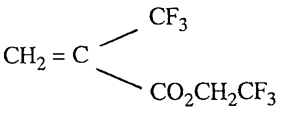

6. Matière de résist selon la revendication 1, dans laquelle ledit acrylonitrile substitué en position α par un groupe attracteur d'électrons est l'α-chloracrylonitrile représenté de la façon suivante:

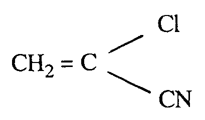

7. Méthode de formation d'un dessin de résist comprenant les étapes selon lesquelles:
on forme une première couche de résist sur un substrat ou une structure de base, et on forme par-dessus une seconde couche de résist,
on irradie ladite seconde couche de résist de façon sélective avec un rayonnement de faisceaux d'électrons/rayons X, et on élimine la seconde couche de résist et on expose (révèle) la première couche de résist sous-jacente dans les régions sélectivement irradiées par un processus de développement, et
on soumet toute la surface du substrat à une opération d'attaque chimique par voie sèche à l'aide d'un gaz contenant de l'oxygène,
la matière de ladite seconde couche de résist étant une matière de résist selon la revendication 1.
